(19) Europäisches Patentamt
European Patent Office
Office européen des brevets

(11) EP 2 573 862 A1

(12) EUROPEAN PATENT APPLICATION
published in accordance with Art. 153(4) EPC

(43) Date of publication:
**27.03.2013 Bulletin 2013/13**

(21) Application number: **11783485.3**

(22) Date of filing: **16.05.2011**

(51) Int Cl.:
***H01M 14/00*** *(2006.01)* ***C08G 59/44*** *(2006.01)*
***C08L 63/00*** *(2006.01)* ***H01L 31/04*** *(2006.01)*

(86) International application number:
**PCT/JP2011/061166**

(87) International publication number:
**WO 2011/145551 (24.11.2011 Gazette 2011/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.05.2010 JP 2010112958**

(71) Applicant: **Nippon Kayaku Kabushiki Kaisha**
**Tokyo 102-8172 (JP)**

(72) Inventors:
- **SATAKE Masamitsu**
  **Tokyo**
  **1158588 (JP)**
- **HOSHI Takayuki**
  **Tokyo**
  **1158588 (JP)**
- **HAMADA Masahiro**
  **Tokyo**
  **1158588 (JP)**
- **IMAIZUMI Masahiro**
  **Tokyo 115-8588 (JP)**
- **SHIGAKI Koichiro**
  **Tokyo 115-8588 (JP)**
- **INOUE Teruhisa**
  **Tokyo 115-8588 (JP)**

(74) Representative: **Gille Hrabal**
**Patentanwälte**
**Brucknerstrasse 20**
**40593 Düsseldorf (DE)**

# (54) PHOTOELECTRIC CONVERSION ELEMENT USING THERMOSETTING SEALING AGENT FOR PHOTOELECTRIC CONVERSION ELEMENT

(57) Disclosed is a photoelectric conversion element which comprises: a first conductive supporting body that has a semiconductor-contairning layer; a second conductive supporting body that has a counter electrode which is arranged at a position where the counter electrode faces the semiconductor-containing layer at a predetermined distance; a charge transfer layer that is held in a space between the first and second conductive supporting bodies; and a sealing agent that is provided in the peripheral portions of the first and second conductive supporting bodies so as to seal the charge transfer layer. The photoelectric conversion element is characterized in that the sealing agent is a thermosetting sealing agent for a Photoelectric conversion element, said thermosetting sealing agent containing (a) an epoxy resin and (b) at least one heat curing agent that is selected from the group consisting of aromatic hydrazides and aliphatic hydrazides having 6 or more carbon atoms.

FIG.1

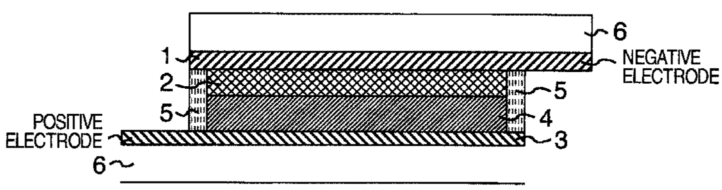


EP 2 573 862 A1

## Description

### Technical Field

The present invention relates to a photoelectric conversion device using a thermosetting sealing agent for a photoelectric conversion device, the thermosetting sealing agent containing an epoxy resin and a specific curing agent, particularly to a highly reliable photoelectric conversion device having excellent adhesiveness and moisture resistance reliability even under a high-temperature high-humidity environment.

### Background Art

Solar cells paid attention to as a clean energy source, although having recently been utilized for common houses, do not yet come to sufficiently spread. The reason includes, for example, that the performance of solar cells themselves cannot be said to be sufficiently good and modules inevitably need to be made large, and that the productivity in module production is low, resulting in high cost.

Photoelectric conversion devices used for solar cells are generally configured by protecting a photoelectric conversion material such as silicon, gallium-arsenic or copper-indium-selenium by an upper transparent protection material and a lower protection substrate material, and fixing the photoelectric conversion material and the protection materials with a sealing agent to package these. Therefore, sealing agents used in production of photoelectric conversion devices are required to have good adhesiveness with upper and lower protection materials, excellent flexibility and durability, and the like as important performance.

As sealing agents for photoelectric conversion devices in solar cell modules, for example, an ethylene-vinyl acetate copolymer having a high content proportion of vinyl acetate is used now from the viewpoint of flexibility, transparency and the like. However, the copolymer exhibits insufficient heat resistance and adhesiveness, an organic peroxide or the like needs to be used in order to more promote the copolymerization reaction. In this case, a two-stage step needs to be employed in which a sheet of an ethylene-vinyl acetate copolymer blended the organic peroxide is first fabricated, and then, a photoelectric conversion material is sealed using the sheet. In the production stage of the sheet, since formation of the sheet needs to be carried out at such a low temperature the organic peroxide does not decompose, the extrusion rate cannot be made high; on the other hand, the sealing (curing adhesion) stage of the photoelectric conversion material needs to be subjected to two steps composed of a step of temporary adhesion taking several minutes to several tens of minutes by a laminator, and a step of regular adhesion taking several tens of minutes to 1 hour in an oven at a high temperature at which the organic peroxide decomposes. Therefore, production of a photoelectric conversion device takes labor and time, and further has the problems of insufficient adhesiveness and moisture resistance reliability. This results in that solar cell modules and solar cells using such a photoelectric conversion device naturally become expensive and exhibit unsatisfactory performance.

In the case of using concurrently the copolymer and an ionomer having a low melting point as a sealing agent for a photoelectric conversion device, since the sealing agent has insufficient heat resistance, the sealing agent may possibly deform to temperature rise in use for a solar cell, and when the photoelectric conversion device is produced by a heat press bonding method, the sealing agent flows out more than necessary to cause flashes in some cases, which is not preferable. Along with recent up-sizing of photoelectric conversion devices, the stress exerted on a sealed part in the processing process has become much higher than conventionally, and the sealing line length also has become long. From these, there is demanded the development of a coating-type sealing agent which is excellent in moisture resistance reliability, allows making the sealing line width narrow, allows making the gap between conductive supports uniform, and further is excellent in tight adhesiveness and pliability.

On the other hand, along with the spread of solar cells, ever-unseen requirements for characteristics of solar cells have emerged, including solar cells exhibiting little environmental load in their production process and disposal, and solar cells of a low cost and of being excellent in designability, and dye-sensitized solar cells concurrently having these features have recently been paid attention to. The dye-sensitized solar cell is a solar cell constituted of an oxide semiconductor carrying a sensitizing dye, a charge transfer layer, a conductive substrate and the like, and has a relatively high conversion efficiency, and high designability because the color tone can be selected by selecting a sensitizing dye to be used. However, since a liquid such as an electrolyte solution is used for the charge transfer layer, the moisture resistance reliability such as excellent adhesiveness, swelling resistance and moisture-absorption resistance under a high-temperature high-humidity environment is demanded for the sealing performance; and since the moisture resistance reliability has a large effect on the durability and reliability oaf the solar cells, the development of a sealing agent excellent in the moisture resistance reliability is considered to be very important.

As an effort to improve the durability of a solar cell, a method is studied which utilizes a thermosetting epoxy resin as a sealing agent (Patent Literature 1). In this case, a cell is fabricated in a process in which a sealing agent is applied on a conductive support by a dispenser, screen printing or the like, then leveled under heating or no heating;

and then, the upper and lower conductive supports are laminated using an alignment mark, and the sealing agent is pressed. A curing agent of the thermosetting epoxy resin used here is a phenol novolac, and such a sealing agent for a photoelectric conversion device is inferior in the adhesiveness performance for the long-term sealing property under a high-temperature high-huinidity environment, and has the problem of the leakage of an electrolyte solution. As a method for solving this problem, Patent Literature 2 discloses a resin composition using a hydrogenated bisphenot-type epoxy resin, but in this case, the long-term sealing property under a high-temperature high-humidity environment cannot be imparted, and an event in which an electrolyte solution leaks is revealed. Patent Literature 3 discloses a resin composition using a bisphenol S-type epoxy resin as a combined light-heat curing sealing agent, which provides excellent cell durability. However, the condition disclosed as a durability test is only an evaluation with time at a constant temperature of 25°C, and is considered to be insufficient for evaluating the durability of a solar cell under the actual use environment. Therefore, there is no report on a sealing agent and a solar cell using the sealing agent capable of passing the durability test under a high-temperature high-humidity environment.

Citation List

Patent Literature

Patent literature 1: JP 2002-368236 A
Patent Literature 2- JP 2007-087684 A
Patent Literature 3: International Publication WO2007-007671
Patent Literature 4 : Japanese Patent No. 3731752
Patent Literature 5: JP 2002-512729 A
Patent Literature 6: International Publication WO2002-011213
Patent Literature 7 - International Publication WO2006-126538
Patent Literature 8: International Publication WO2007-046499

Non Patent Literature

Non Patent Literature 1: C. J. Barbe, F Arendse, P Compt and M. Graetzel J. Am. Ceram. Soc., 80, 12, 3157-71(1997)

Summary of Invention

Technical Problem

A thermosetting sealing agent for a photoelectric conversion device used in the photoelectric conversion device according to the present invention is very low in the contamination of a charge transfer layer in the production step of the photoelectric conversion device, and is excellent in application workability to a substrate, laminating property, adhesive strength, usable time at room temperature (pot life) and low-temperature curability. The photoelectric conversion device according to the present invention obtained using such a sealing agent exhibits no operational failures due to contamination of a charge transfer layer, is excellent in adhesiveness and moisture resistance reliability, and has high durability and reliability,

Solution to Problem

As a result of exhaustive studies to solve the above-mentioned problems, the present inventors have found that a resin composition having a specific composition the above-mentioned problems, and this finding has led to the completion of the present invention.
That is, the present invention relates to :

(1) a photoelectric conversion device comprising a first conductive support haying a semiconductor-containing layer, a second conductive support having a counter electrode and provided a position where the semiconductor-containing layer and the counter electrode face each other with a predetermined gap, a charge transfer layer interposed in the gap between the first and second conductive supports, and a sealing agent provided on circumferential parts of the first and the second conductive support in order to seal the charge transfer layer, the sealing agent is a thermosetting

sealing agent, for a photoelectric conversion device, comprising an epoxy resin (a) and a curing (b) containing at least one selected from the group consisting of aromatic hydrazides and aliphatic hydrazides having 6 or more carbon atoms;

(2) the photoelectric conversion device according to the above (1), wherein the heat curing agent (b) contain 0.8 to 3.0 equivalent weights of an active hydrogen with respect to 1 equivalent weight of an epoxy group in the epoxy resin (a);

(3) the photoelectric conversion device according to the above (1) or (2), wherein at least one of aromatic hydrazides and aliphatic hydrazides haying 6 or more carbon atoms contained in the heat curing agent (b) has two or more hydrazide groups in a molecule thereof;

(4) the photoelectric conversion device according to any one of the above (1) to (3), wherein the heat curing agent (b) comprises an aromatic hydrazide;

(5) the photoelectric conversion device according to any one of the above (1) to (4), wherein the heat curing agent (b) further comprises a phenol novolac resin;

(6) the photoelectric conversion device according to any one of the above (1) to (5), wherein the thermosetting sealing agent for a photoelectric conversion device further comprises a filler (c);

(7) the photoelectric conversion device according to the abode (6), wherein the filler (c) comprises one or two or more selected from the group consisting of hydrous magnesium silicate, calcium carbonate, aluminum oxide, crystalline silica and fused silica, and wherein the filler (c) has an average particle diameter of 15 $\mu$m or smaller;

(8) the photoelectric conversion device according to any one of the above (1) to (7), wherein the thermosetting sealing agent for a Photoelectric conversion device further comprises a silane coupling agent (d);

(9) the photoelectric conversion device according to the above (8), wherein the silane coupling agent (d) is a glycidylethoxysilane or a glycidylmethoxysilane;

(10) the photoelectric conversion device according to the above (9), wherein the silane coupling agent (d) is a glycidyimethoxysilane; and

(11) a solar cell having the photoelectric conversion device according to any one of the above (1) to (10).

Advantageous Effects of Invention

A thermosetting sealing agent for a photoelectric conversion device used in the photoelectric conversion device according to the present invention is very low contamination of a charge transfer layer in the production step of the photoelectric conversion device, and is excellent in application workability to a substrate, laminating property, adhesive strength, usable time at room temperature (pot life) and low-temperature curability The photoelectric conversion device according to the present invention obtained using such a sealing agent exhibits no operational failures due to contamination of a charge transfer layer, is excellent in adhesiveness and moisture resistance reliability, and has high durability and reliability.

Brief Description of Drawings

Fig. 1 is an essential part cross-sectional schematic diagram illustrating a structure of the dye-sensitized photoelectric conversion device according to the present invention,

Description of Embodiments

A thermosetting sealing for a photoelectric conversion device (hereinafter, simply referred to as "sealing agent" in some cases) used in the photoelectric conversion device according to the present invention is a curing resin composition for a photoelectric conversion device, comprising an epoxy resin (a) and a heat curing agent (b) containing at least one selected from the group consisting of aromatic hydrazides and aliphatic hydrazides having 6 or more carbon atoms, and the curing resin composition is used as a sealing in the photoelectric conversion device configured by facingly arranging a first conductive support haying a semiconductor-containing layer and a second conductive support haying a counter electrode with a predetermined gap so that the semiconductor-containing layer and the counter electrode face each other, and interposing a charge transfer layer in the gap between the first and second conductive supports through the sealing provided on a circumferential part of the charge transfer layer.

An epoxy resin (a) used in the present invention is an epoxy resin having at least two epoxy groups one molecule thereof. Such an epoxy resin includes, for example, novolac epoxy resins, bisphenol A-type epoxy resins, bisphenol F-type epoxy resins, bisphenol S-type epoxy resins, biphenyl epoxy resins and triphenylmethane epoxy resins, More specifically, the epoxy resin includes solid or liquid epoxy resins including: trisphenolmethane novolac epoxy resins; glycidyl etherified substances derived from polycondensates and modified substances thereof of bisphenol A, bisphenol F, bisphenol S, fluorene bisphenol, terpene diphenol, 4,4'-biphenol, 2,2'-biphenol, 3,3',5,5'-tetramethyl-[1,1'-biphenyl]-4,4'-diol, hydroquinone, resorcin, naphthalenediol, tris-(4-hydroxyphenyl)methane, 1,1,2,2-tetrakis(4-hydroxyphenyl) ethane or phenols (phenol alkylated phenols, naphthol, alkylated naphthols, dihydroxybenzene, dihydroxynaphthalene, or the like) with formaldehyde, acetaldehyde, benzaldehyde, p-hydroxybenzaldehyde, o-hydroxybenzaldehyde, p-hydroxyacetophenone, o-hydroxyacetophenone, dicyclopentadiene, furfural, 4,4'-bis(chloromethyl)-1,1'-biphenyl, 4,4'-bis (methoxymethyl)-1,1'-biphenyl, 1,4-bis(chloromethyl)benzene, 1,4-bis(methoxymethyl)benzene or the like, or halogenated bisphenols such as tetrabromobisphenol A, or alcohols; alicyclic epoxy resins; glycidylamine-based epoxy resins; and glycidyl ester-based epoxy resins. The epoxy resin is preferably solid or liquid epoxy resins including novolac epoxy resins, bisphenol A-type epoxy resins, bisphenol F-type epoxy resins, glycidyl etherified substances derived from halogenated bisphenols such as tris-(4-hydroxyphenyl)methane and tetrabromobisphenol A, or alcohols, alicyclic epoxy resins, glycidylamine-based epoxy resins and glycidyl ester-based epoxy resins, and more preferably trisphenolmethane novolac epoxy resins and bisphenol A-type epoxy resins. These may be used singly or in combinations of two or more. Selection of these epoxy resins is beneficial to reduce the viscosity of a thermosetting sealing agent for a photoelectric conversion device used for the photoelectric conversion device according to the present invention, allows the lamination working at room temperature, and facilitates the gap formation.

A sealing agent used for the photoelectric conversion device according to the present invention preferably contains as small an amount as possible of hydrolyzable chlorine in order to make the contamination of a charge transfer layer with the sealing agent as low as possible. Therefore, an epoxy resin (a) also is preferably one containing a hydrolyzable chlorine amount of 600 ppm or smaller, and more preferably 300 ppm or smaller. The hydrolyzable chlorine amount can be quantitatively determined, for example, by dissolving about 0.5 g of an epoxy resin in 20 ml of dioxane, refluxing the solution with 5 ml of a 1 N KOH/ethanol solution for 30 min, and thereafter titrating the resultant with a 0.01 N silver nitrate solution.

The content of an epoxy resin (a) in a sealing agent used for the photoelectric conversion device according to the present invention is usually 5 to 80% by mass, preferably 10 to 70% by mass, and more preferably 20 to 60% by mass.

In a sealing agent used for the photoelectric conversion device according to the present invention, a heat curing agent (b) comprises an aromatic hydrazide and/or an aliphatic hydrazide haying 6 or more carbon atoms. These hydrazides to be preferably used are polyfunctional hydrazides having two or more hydrazide groups in a molecule thereof Specific examples of the polyfunctional hydrazides having two or more hydrazide groups in a molecule thereof include: aliphatic dihydrazides having 6 or more carbon atoms including dibasic acid dihydrazides composed of a fatty acid skeleton such as adipic acid dihydrazide, pimelic acid dihydrazide, suberic acid dihydrazide, azelaic acid dihydrazide, sebacic acid dihydrazide, dodecanedioic acid dihydrazide and hexadecanoic acid dihydrazide; aromatic dihydrazides and aromatic polyhydrazides such as isophthalic acid dihydrazide, terephthalic acid dihydrazide, 2,6-naphthoic acid dihydrazide, 4,4-bisbenzene dihydrazide, 1,4-naphthoic acid dihydrazide, 2,6-pyridine dihydrazide, 1,2,4-benzene trihydrazide, pyromellitic acid tetrahydrazide, 1,4,5,8-naphthoic acid tetrahydrazide, phthalic acid dihydrazide, methylphthalic acid dihydrazide, ethylphthalic acid dihydrazide, methoxyphthalic acid dihydrazide, ethoxyphthalic acid dihydrazide, phenoxyphthalic acid dihydrazide, hydroxyisophthalic acid dihydrazide, aminophthalic acid dihydrazide, furandicarboxylic acid dihydrazide, quinolinic acid dihydrazide, benzenesulfonic acid dihydrazide and naphthalenedisulfonic acid dihydrazide; and dihydrazides having a valine hydantoin skeleton such as 1,3-bis(hydrazinocarbonoethyl)-5-isopropylhydantoin. In the case of using an aliphatic hydrazide having 5 or less carbon atoms, the water absorption of a cured substance becomes high and the moisture resistance reliability decreases. These aromatic hydrazides and/or aliphatic hydrazides having 6 or more carbon atoms may be used singly or in combinations of two or more.

These hydrazides are preferably homogeneously dispersed and used in an epoxy resin (a) by making the particle diameter fine so as to act as a latent curing agent. When the average particle diameter of a polyfunctional hydrazide is too large compared to the cell gap (the gap between the first conductive support and the second conductive support) of the photoelectric conversion device, failures including that the gap formation cannot be done well when two substrates (conductive supports) of the photoelectric conversion device are laminated are sometimes seen. Therefore, the average particle diameter is usually equal to or smaller than a cell gap, and is preferably made 3 $\mu$m or smaller, and more preferable 2 $\mu$m or smaller. The particle diameter of these hydrazides can be measured, for example, by a laser diffraction/scattering particle size distribution analyzer (dry type)(LMS-30, made by Seishin Enterprise Co., Ltd.).

A heat curing agent (b) contained in a sealing agent used in the photoelectric conversion device according to the present invention may concurrently contain, in addition to aromatic hydrazides and/or aliphatic hydrazides having 6 or more carbon atoms, amines, guanamines, imidazoles and the like. The amines concurrently usable are not especially limited as long as being ones known as curing agents of epoxy resins, and include, for example, diaminodiphenylmethane, diethylenetriamine, triethylenetetramine, diaminodiphenyl sulfone, isophoronediamine, and polyamide resins synthesized from a dimer of linoleic acid and ethylenediamine. The guanamines concurrently usable are not especially limited, and include, for example, dicyandiamide, o-toluylbiguanide, acetoguanamine, benzoguanamine and phenylacetoguanamine.

The imidazoles concurrently usable are not especially limited, and include, for example, 2-ethylimidazole, 2-methylimidazole, 2-phenylimidazole, 2-undecylimidazole, 2-heptadecylimidazole, 2-ethyl-4-methylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-phenylimidazole, 1-cyanoethyl-2-undecylimidazole, 2,4-dicyano-6-(2'-methylimidazole(1'))ethyl-s-triazine and 2,4-dicyano-6-(2'-undecylimid&zole(1'))ethyl-s-triazine.

Additionally, other heat curing agents concurrently usable include, for example, polyfunctional novolacs such as phenol-formaldehyde polycondensates, cresol-formaidehyde polycondensates, hydroxybenaldehyde-phenol polycondensates, cresol-naphthol-formaldehyde polycondensates, resorcin-formaldehyde polycondensates, furfural-phenol polycondensates, phenol novolac resins and $\alpha$-hydroxyphenyl-$\omega$-hydropoly(biphenyldimethylene-hydroxyphenylene); polyhydric phenolic curing agents including polycondensates and modified substances thereof of bisphenol A, bisphenol. F, bisphenol S, thiodiphenol, 4,4'-biphenylphenol, dihydroxynaphthalene, fluorene bisphenol, terpene diphenol, 2,2'-biphenol, 3,3',5,5'-tetramethyl-[1,1'-biphenyl]-4,4'-diol, hydroquinone, resorcin, naphthalenediol, tris-(4-hydroxyphenyl) methane, 1,1,2,2-tetrakis(4-hydroxyphenyl)ethane or phenols (phenol, alkylated phenols, naphthol, alkylated naphthols, dihydroxybenzene, or the like) with formaldehyde, acetaldehyde, benzaldehyde, p-hydroxybenzaldehyde, o-hydroxybenzaldehyde, p-hydroxyacetophenone, o-hydroxyacetophenone, dicyclopentadiene, furfural, 4,4'-bis(chloromethyl)-1,1'-biphenyl, 4,4'-bis(methoxymethyl)-1,1'-biphenyl, 1,4-bis(chloromethyl)benzene, 1,4-bis(methoxymethyl)benzene or the like, halogenated bisphenols such as tetrabromobisphenol A, and condensates of terpene and phenols, acid anhydride curing agents such as phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, methylhexahydrophthalic anhydride and benzophenonetetracarboxylic anhydride; and aliphatic hydrazides having 5 or less carbon atoms. These heat curing agents concurrently usable may be used singly or in combinations of two or more.

The use amount of the heat curing agent concurrently usable is usually 50% by mass or smaller, and preferably 30% by mass or smaller, with respect to the total amount of a heat curing agent (b) in a sealing agent used for the photoelectric conversion device according to the present invention. The content of a heat curing agent (b) in the total amount of a sealing agent is, in weight ratio, usually 0.1% to 30%, preferably 1% to 20%, more preferably 5% to 14%, and especially preferably 10% to 13%.

Regarding the content of a heat curing agent (b) used for a sealing agent used for the photoelectric conversion device according to the present invention, active hydrogen in the heat curing agent (b) is preferable 0.8 to 3.0 equivalent weights, and preferably 0.9 to 2.0 equivalent weights with respect to 1 equivalent weight of an epoxy group in an epoxy resin (a) used for the sealing agent. If the amount of the active hydrogen in a heat curing agent (b) is smaller than 0.8 equivalent weight with respect to I equivalent weight of an epoxy group, the heat curing reaction becomes insufficient, and there arises a risk that the adhesive force with conductive supports and the glass transition temperature of a cured substance of a sealing agent decrease. If the amount of the active hydrogen is larger than 3.0 equivalent weights, there arise apprehensions that the adhesive force with conductive supports decreases due to an unreacted heat curing agent remaining in a sealing agent after curing, and that the pot life of the sealing agent deteriorates, The active hydrogen refers to a hydrogen atom having a bond with a heteroatom of a heat curing agent reactive with an epoxy group of an epoxy resin.

As a heat curing agent (b), single use of an aromatic hydrazide, or concurrent use of two or more thereof, or concurrent use of an aromatic hydrazide and a phenol novolac resin is preferable. The concurrent use of an aromatic hydrazide and a phenol novolac resin allows providing a sealing agent excellent in moisture resistance reliability; and the case of using the sealing agent allows providing a photoelectric conversion device excellent in durability and reliability. The aromatic hydrazide used in the concurrent use is preferably isophthalic acid dihydrazide, terephthalic acid dihydrazide, 2,6-naphthoic acid dihydrazide, 4,4-bisbenzene dihydrazide, 1,4-naphthoic acid dihydrazide, 2,6-pyridine dihydrazide, 1,2,4-benzene trihydrazide, pyromellitic acid tetrahydrazide and 1,4,5,8-naphthoic acid tetrahydrazide, and especially preferably is isophthalic acid dihydrazide.

For a sealing agent used for the photoelectric conversion device according to the present invention, a filler (c) can be used, as required. Specific examples of the filler (c) to be used include fused silica, crystalline silica, silicon carbide, silicon nitride, boron nitride, calcium carbonate, magnesium carbonate, barium sulfate, calcium sulfate, mica, talc, clay, alumina (aluminum oxide), magnesium oxide, zirconium oxide, aluminum hydroxide, magnesium hydroxide, hydrous magnesium silicate, calcium silicate, aluminum silicate, lithium aluminum silicate, zirconium silicate, barium titanate, glass fibers, carbon fibers, molybdenum disulfide, and asbestos. Above all, preferable are hydrous magnesium silicate, calcium carbonate, aluminum oxide, crystalline silica and fused silica. These fillers may be used singly or as a mixture of two or more. A filler (c) which a sealing agent used for the photoelectric conversion device according to the present invention can contain preferably has an average particle diameter of 15 $\mu$m or smaller. If the average particle diameter is larger than 15 $\mu$m, when and lower substrates are laminated in production of a photoelectric conversion device, suitable gap formation cannot be carried out in some cases.

The content of a filler (c) in the case of being used is usually 60% by mass or lower, preferably 5 to 60% by mass, and more preferably 15 to 50% by mass, in a sealing agent used for the photoelectric conversion device according to the present invention. If the content of a filter exceeds 60% by mass, in fabrication of the photoelectric conversion device, a suitable cell gap to hold a charge transfer layer cannot be formed in some cases.

In a sealing agent used for the photoelectric conversion device according to the present invention, a silane coupling agent (d) can be used in order to improve the adhesive strength, The silane coupling agent (d) usable is any one as long as being capable of improving the adhesive strength between the sealing agent and conductive supports. Specific examples of the silane coupling agent usable include methoxysilanes such as 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane and N-(2-aminoethyl)3-aminopropylmetbyldimethoxysilane, and ethoxysilanes such as 3-aminopropyltriethoxysilane, 3-mercaptopropyltriethoxysilane, vinyltrimethoxysilane, N-(2-(vinylbenzylamino)ethyl)3-aminopropyltriethoxysilane hydrochlorides, 3-methacryloxypropyltriethoxysilane, 3-chloropropylmethyldiethoxysilane and 3-chloropropyltriethoxysilane; but glycidylethoxysilanes or glycidylmethoxysilanes are preferable; glycidylmethoxysilanes are more preferable, and 3-glycidoxypropylmethyldimethoxysilane is especially preferable. Silane coupling agents having an amino group also are preferably used in order to acquire good adhesive strength. Preferable ones among the silane coupling agents having an amino group include N-(2-aminoethyl)3-aminopropylmethyldimethoxysilane, N-(2-aminoethyl)3-aminopropylmethyldimethoxysilane, 3-aminopropyltriethoxysilane, and N-(2-(vinylbenzylamino)ethyl)3-aminopropyltriethoxysilane hydrochlorides. These silane coupling agents may be used singly or as a mixture of two or more. In the present invention, in the case of using a silane coupling agent, the content is usually 2% by mass or lower, preferably 0.1 to 2% by mass, and more preferable 0. 2 to 1.5% by mass, in a sealing agent used for the photoelectric conversion device according to the present invention.

Further in a sealing agent used for the photoelectric conversion device according to the present invention, as required, organic solvents, organic fillers, stress relaxing agents, and further additives such as pigments, leveling agents and antifoaming agents can be blended. Additives blendable are not especially limited, and the addition amount also may be suitably selected according to purposes, but addition of additives having an effect of preventing leakage of a charge transfer layer, and additives having an effect of reducing the contamination of a charge transfer layer is preferable.

A sealing agent used for the photoelectric conversion device according to the present invention can be produced by mixing the epoxy resin (a) and the heat curing agent (b), and as required, the filler (c), the silane coupling agent (d) and various types of additives in the above-mentioned respective contents in an optional order under stirring as required, and homogeneously mixing the mixture by a mixing apparatus such as a three-roll mill, a sand mill or a ball mill. As required, a filtration treatment may be carried out after the mixing in order to remove foreign matters.

A sealing agent used for the photoelectric conversion device according to the present invention is suitable for a method for fabricating the photoelectric conversion device in which the sealing agent is used and a charge transfer layer is injected from an injection port after two substrates (conductive supports) are laminated; and a weir of the sealing agent interposed between the two substrates is heated and cured to carry out sealing of the charge transfer layer. A method for applying a sealing agent on a substrate includes a bar coater method, a dip coating method, a spin coat method, a spray method, a screen printing method, a doctor blade method, a dispensing method and an inkjet printing method, and although suitable selection therefrom or concurrent use thereof is possible according to kinds and forms of substrates, a spray method, a screen printing method, a dispensing method or an inkjet printing method is preferably used from the viewpoint of productivity. A photoelectric conversion device to which a sealing agent used for the photoelectric conversion device according to the present invention can be applied generally includes every device to convert an optical energy to an electric energy. A cell is made by disposing lead wires so that a current generated from the photoelectric conversion device is taken out and making a closed circuit. A sealing agent used for the photoelectric conversion device according to the present invention is best especially for productions of a dye-sensitized photoelectric conversion device and a solar cell having the photoelectric conversion device.

By using a sealing agent used for the photoelectric conversion device according to the present invention so that the sealing width after heat curing becomes 0.01 mm to 1 cm, preferably 0.01 mm to 5 mm, more preferably 0.1 mm to 5 mm, and especially preferably 1 mm to 3 mm, the property of preventing leakage of an electrolyte solution can be improved, and the durability of a solar cell can be improved. The sealing agent is used not only for sealing the circumference of a solar cell, but can be used for sealing an injection port of a charge transfer layer as described later. In the case where a solar cell has a plurality of cells electrically connected including an internal series structure, the sealing agent can be used also as a weir between one cell and another. In the case where a sealing agent used for the photoelectric conversion device according to the present invention is used for sealing the circumference of a solar cell, the sealing agent may be arranged doubly or more.

Hereinafter, a dye-sensitized photoelectric conversion device and a dye-sensitized solar cell according to the present invention will be described in detail, A dye-sensitized photoelectric conversion device is constituted, as major constituting elements, of a first conductive support (oxide semiconductor electrode) haying a dye-sensitized semiconductor-containing layer on the surface, a second conductive support as a counter electrode, and a charge transfer layer; and a thermosetting sealing agent for a photoelectric conversion device used for the photoelectric conversion device according to the present invention is used for bonding the first and second conductive supports and holding the charge transfer layer between both the supports. The conductive support to be used is, for example, a substrate, such as glass,

plastic, polymer film, quartz or silicon, having a thin film of a conductive substance represented by FTO (fluorine doped tin oxide), ATO (antimony-doped tin oxide), or ITO (indium-doped tin oxide) on the substrate surface. The thickness of the substrate is usually 0.01 to 10 mm, and the shape may assume one of various forms from a film shape to a plate shape; but at least one of the two substrates to be used is a substrate having optical transparency, The conductivity of the conductive support usually 1,000 $\Omega/cm^2$ or lower, and preferably 100 $\Omega/cm^2$ or lower.

An oxide semiconductor used for preparation of a semiconductor-containing layer is preferably a metal chalcogenide microparticle; and specific examples thereof include oxides of transition metals such as Ti, Zn, Sn, Nb, W, In, Zr, Y, La and Ta, an oxide of Al, an oxide of Si, and perovskite-type oxides such as $StTiO_3$, and $BaTiO_3$. Above all, $TiO_2$, ZnO and $SnO_2$ are especially preferable, These may be mixed and used, and preferable examples include a $SnO_2$-ZnO mixture system. In the case of a mixture system, the system used may be mixed in a microparticle state, or may be mixed in a slurry or paste state as described later, or each component may be stacked in layers. The primary particle diameter of an oxide semiconductor used here is usually to 200 nm, and preferably 1 to 50 nm. A composite oxide semiconductor fabricated by mixing titanium with a non-titanium metal or the like such as magnesium, zirconium or strontium for example, as described in International Publication WO2006/080384 may be used as the oxide semiconductor, and can suitably be used for improvements in the open voltage, the conversion efficiency and the durability of a dye-sensitized photoelectric conversion device.

A method for preparing a semiconductor-containing layer includes a method of fabricating a thin film composed of an oxide semiconductor directly on a substrate by vapor deposition, a fabrication method by application or coating of a slurry or a paste on a substrate, and subsequent application of a pressure, a method of electrical deposition using the substrate us an electrode, and a method by application or coating of a slurry or a paste on a substrate, and subsequent drying and curing or firing. The applying or coating method includes a bar coater method, a dip coating method, a spin coat method, a. spray method, a screen printing method, a doctor blade method, a dispensing method and an inkjet printing method; and suitable selection or concurrent use thereof is possible according to kinds and forms of substrates. A method using a slurry or a paste is preferable from the viewpoint of the performance of an oxide semiconductor electrode. A slurry can be obtained by dispersing microparticles secondarily aggregated of an oxide semiconductor in a dispersion medium using a dispersant so that the average primary particle diameter usually becomes 1 to 200 nm, or hydrolyzing an alkoxide or the like as a precursor of an oxide semiconductor by a sol-gel method. Microparticles having different particle diameters of an oxide semiconductor may be mixed and used.

The dispersion medium to disperse a slurry is not especially limited as long as being capable of dispersing microparticles of an oxide semiconductor. As the dispersion medium, water or organic solvents can be used, and the organic solvents include alcohols such as ethanol and terpineol, ketones such as acetone and acetylacetone, and hydrocarbons such us hexane, and these may be mixed and used. Using water is preferable from the viewpoint of reducing the viscosity change of the slurry.

In order to obtain a stable primary microparticle, a dispersion stabilizer and the like may be added to a slurry. Specific examples of a dispersion stabilizer usable include polyhydric alcohols such as polyethylene glycol, self- or co-condensates of monohydric alcohols such as phenol and octyl alcohol; cellulose derivatives such as hydroxylpropyl methyl cellulose, hydroxylmethyl cellulose, hydroxylethyl cellulose and carboxymethyl cellulose, polyacrylamides-, self- or co-condensates of acrylamide, (meth)acrylic acid or salts thereof, and (meth)acrylate esters (methyl (meth)acrylate, ethyl (meth)acrylate and the like); polyacrylic acid-based derivatives which are water-soluble and copolymers of acrylamide, (meth)acrytic acid or salts thereof, (meth)acrylate esters and the like with hydrophobic monomers such as styrene, ethylene and propylene; salts of melaminesulfonic acid-formaldehyde condensates; salts of naphthalenesulfonic acid-formaldehyde condensates; high-molecular weight ligninsulfonic acid salts, and acids such as hydrochloric acid, nitric acid and acetic acid, but are not limited thereto, These dispersion stabilizers may be used singly or in combinations of two or more.

Above all, preferable are polyhydric alcohols such as polyethylene glycol; self- or co-condensates of phenol and octyl alcohol etc.; poly(meth)acrylic acid; sodium poly(meth)acrylate; potassium poly(meth)acrylate; lithium poly (meth)acrylate; carboxymethyl cellulose; hydrochloric acid; nitric acid; acetic acid; and the like.
The concentration of an oxide semiconductor in a slurry is usually 1 to 90% by mass, and preferable 5 to 80% by mass.

After a slurry applied on a conductive support is dried, a firing treatment is carried out at a temperature equal to or lower than the melting point (or the softening point) of a substrate used for the conductive support. The firing temperature is usually 100 to 900°C, and preferably 100 to 600°C. The firing time is not especially limited, but is within about 4 hours. The film thickness of a semiconductor-containing layer provided on the conductive support, depending on a sensitizing dye, a charge transfer layer and the like to be used, is usually about 1 to 50 μm, preferably 1 to 40 μm, and more preferably 3 to 30 μm.

In order to improve the surface smoothness, the semiconductor-containing layer may be subjected to a secondary treatment (see Non Patent Literature 1). The smoothness of a semiconductor-containing layer can be enhanced, for example, by immersing a conductive support provided with a thin film of a semiconductor-containing layer prepared by the above-mentioned means directly in a solution of an alkoxide, a chloride, a nitride, a sulfide or the like of the same

metal as used in the preparation of the semiconductor-containing layer, and drying or firing (refiring) the resultant as described above. Here, the metal alkoxide includes titanium ethoxide, titanium isopropoxide, titanium t-butoxide and n-dibutyl-diacetyltin, and an alcohol solution thereof is used. The chloride includes, for example, titanium tetrachloride, tin tetrachloride and zinc chloride, and an aqueous solution thereof is used. The specific surface area of a semiconductor-containing layer composed of an oxide semiconductor microparticle thus obtained is usually 1 to 1,000 $m^2$/g, and preferably 10 to 500 $m^2$/g.

Then, a step of making a semiconductor-containing layer carry a sensitizing dye will be described. The sensitizing dye is not especially limited as long as being one having an action to sensitize the optical absorption in cooperation with a semiconductor microparticle constituting the semiconductor-containing layer; and metal complex dyes containing a metal element such as ruthenium and organic dyes containing no metal may be used singly, or may be used as a mixture of several kinds thereof in an optional proportion. In the case of the mixture, the mixture may be any of mixtures of fellow metal complex dyes, fellow organic dyes, and combinations of metal complex dyes and organic dyes; and mixing together dyes having different absorption wavelength regions allows use of broad absorption wavelength, and can provide a solar cell having a high conversion efficiency.

The metal complex dye to be carried is not especially limited, but the ruthenium complex dyes described in Patent literature 4 and Patent Literature 5 shown above, phthalocyanine, porphyrin, and the like are preferable, and the ruthenium complexes are more preferable. The organic dye to be carried includes, for example, non-metallic phthalocyanines, porphyrins, cyanines, merocyanines, oxonols, triphenylmethane-based dyes, acrylic acid-based dyes described in Patent Literature 6 shown above, methine-based dyes such as pyrazolone-based methine dyes described in Patent Literature 7 shown above, and dyes of xanthene-based, azo-based, anthraquinone-based, perylene-based and the like; preferable are dyes described in International Publication WO2002-001667, Patent Literature 7, International Publication WO2002-071530, JP 2002-334729 A, JP 2003-007358 A, JP 2003-017146 A, JP 2003-059547 A, JP 2003-086257 A, JP 2003-115333 A, JP 2003-132965 A, JP 2003-142172 A, JP 2003-151649 A, JP 2003-157915 A, JP 2003-282165 A, JP 2004-014175 A, JP 2004-022222 A, JP 2004-022387 A, JP 2004-227825 A, JP 2005-005026 A, JP 2005-019130 A, JP 2005-135656 A, JP 2006-079898 A, JP 2006-134649 A, International Publication WO2006-082061, JP 2008-021496 A, International Publication WO2009/020098, JP 2010-146864 A, International Publication WO2010/021378, and International Publication WO2007/100033, and more preferable are merocyanines, methine-based dyes such as acrylic acid-based ones as described above, and the like. The ratio of dyes in the case where the dyes are mixed and used is not especially limited, but is preferably generally at least about 10 mol% or more for each dye. In the case where dyes are made to be carried in a semiconductor-containing layer by using a solution in which two oar more dyes are dissolved or dispersed, the concentration of the total of the dyes in the solution may be the same as that of the case where only one kind of dye is carried. As solvents used in the case where dyes are mixed and used, solvents described below can be used, and the solvents may be identical or different for each dye to be used.

A method of making a sensitizing dye to be carried includes a method in which the conductive support provided with a semiconductor-containing layer is immersed in a solution containing dyes dissolved in a solvent, or a dispersion liquid containing dyes dispersed in a solvent. The concentration of the dyes in the solution or the dispersion liquid may be decided suitably according to the kinds and solubilities of the dyes. The immersion temperature is nearly a temperature from normal temperature to the boiling point of the solvent, the immersion time is about 1 hour to 72 hours. Specific examples of a solvent usable for dissolving sensitizing dyes include methanol, ethanol, acetonitrile, acetone, dimethyl sulfoxide, dimethylformamide, n- propanol, t-butanol and tetrahydrofuran, and these may be used singly or as a mixture of two or more in an optional proportion. The concentration of sensitizing dyes in a solution is usually $1 \times 10^{-6}$ M to 1 M, and preferably $1 \times 10^{-5}$ M to $1 \times 10^{-1}$ M. By immersing a conductive support provided with a semiconductor-containing layer carrying a sensitizing dye in such a manner, the conductive support having a dye-sensitized semiconductor-containing layer is obtained,

When dyes are carried in a semiconductor-containing layer, in order to prevent the association of dyes, the carrying of the dyes in the coexistence of a clathrate compound is effective. The clathrate compound includes steroid-based compounds such as cholic acids, crown ethers, cyclodextrins, calixarenes and polyethylene oxides; but cholic acids are preferably used, and among cholic acids, preferably used are deoxycholic acid, chenodexycholic acid, cholic acid methyl ester, sodium cholate, ursodeoxycholic acid, lithocholic acid, and the like, and more preferably are deoxycholic acid, chenodexycholic acid, ursodeoxycholic acid, and lithocholic acid. The use forms of these clathrate compounds may involve the addition to a dye solution, or the dissolution or dispersion of a dye after a clathrate compound is dissolved in a solvent in advance. These clathrate compounds may be used in combinations of two or more and the proportion thereof may be optionally selected, After a dye is carried, the semiconductor-containing layer may be treated with an amine compound such as 4-t-butylpyridine, pyridine, 4-methylpyridine or triethylamine, or an acid such as formic acid, acetic acid or propionic acid. A method of the treatment to be employed includes, for Example, a method in which a conductive support provided with a semiconductor-containing layer carrying a sensitizing dye is immersed in an ethanol solution to which an amine compound or an acid ins added, and a method in which an amine compound or an acid is directly added to and brought into contact with a conductive support provided with a semiconductor-containing layer

carrying a sensitizing dye, and cleaned with an organic solvent, water or the like after a certain time, and dried.

A counter electrode to be used is obtained by vapor depositing platinum, carbon, rhodium, ruthenium or the like, which catalytically acts on the reduction reaction of a redox electrolyte, on the surface of a conductive support such as FTO conductive glass, or applying and firing a conductive microparticle precursor thereon.

Then, a method will be described in which the conductive support (oxide semiconductor electrode) having a dye-sensitized semiconductor-containing layer and the conductive support haying a counter electrode, obtained as described above, are laminated using a thermosetting sealing agent for a photoelectric conversion device. First, a sealing agent so which a spacer (gap control material) is added is applied in a weir-shape on the circumference part of the conductive surface of one of the conductive supports by a dispenser, a screen printing machine, an inkjet printing machine or the like, with an injection port for a charge transfer layer being left; thereafter, in the case where the sealing agent contains a solvent, the solvent is evaporated, for example, by heating at 90°C for 18 min; and then, the other conductive support is overlaid so that the conductive surfaces of the first and second conductive supports face each other, and the sealing agent is cured by heating. The spacer is, for example, glass fibers, silica beads, polymer beads or the like, or microparticles coated with a metal such as gold pearl of silver pearl, or the like. The diameter, depending on the purpose, is usually 1 to 100 μm, and preferably 10 to 40 μm. The use amount is usually 0.1 to 10 parts by mass, preferably 0.5 to 5 parts by mass, and more preferably 1 to 2.5 parts by mass, with respect to 100 parts by mass of a sealing agent. The heat curing conditions for a sealing agent is usually 90 to 180°C and 1 to 3 hours. A method of heat curing to be employed includes a method in which the heat curing is carried out by sandwiching by a hot press having two hot plates, and a method in which the heat curing is carried out in an oven after fixation by a jig. The gap between the first and second conductive supports is usually 1 to 100 μm, and preferable 4 to 50 μm.

The dye-sensitized photoelectric conversion device according to the present invention is completed by injecting a charge transfer layer in the gap between the pair of conductive supports laminated as described above. The charge transfer layer to be used is a solution in which a redox pair electrolyte, a hole transport material and the like are dissolved in a solvent or a normal temperature fused salt (ionic liquid). The redox electrolyte usable includes halogen redox electrolytes composed of a halogen compound having a halogen ion as a counter ion and the halogen molecule, metal redox electrolytes including metal complexes such as ferrocyanate salt-ferricyanate salts, ferrocene-ferricinium ions and cobalt complexes, and organic redox electrolytes such as alkylthiol-alkyl disulfides, viologen dyes and hydroquinone-quinone, but preferable are halogen redox electrolytes. A halogen molecule in the halogen redox electrolytes includes, for example, an iodine molecule and a bromine molecule, and preferable ins an iodine molecule. The halogen compound includes, for example, halogenated metal salts such as LiI, NaI, KI, CsI, $CaI_2$ and CuI, tetraalkylammonium iodide, imidazolium iodine, 1-methyl-3-alkylimidazolium iodides such as 1-methyl-3-propylimidazolium iodide, 1-methyl-3-ethylimidazolium iodide, 1-methyl-3-butylimidazolium iodide and 1-methyl-3-hexylimidazolium iodide, 1,2-dimethyl-3-alkylimidazolium iodides such as 1,2-dimethyl-3-propylimidazolium iodide, 1,2-dimethyl-3-butylimidazolium iodide and 1,2-dimethyl-3-hexylimidazolium iodide, N,N-dialkylpyrrolidinium iodides such as N,N-dimethylpyrrolidinium iodide and N, N-dibutylpyrrolidinium iodide, and organic quaternary ammonium salts of halogens such as pyridinium iodide, but preferable are salts having iodine ions as the counter ion. Preferable examples of salt compounds having iodine ions as the counter ion include lithium iodide, sodium iodide, trimethylammonium iodide salts, tetrabutylammonium iodide and N, N-imidazolium iodide.

In the case where the charge transfer layer is constituted of a form of a solution containing a redox electrolyte, the solvent to be used is an electrochemically inactive one. Examples of solvents usable include acetonitrile, valeronitrile, propylene carbonate, ethylene carbonate, 3-methoxypropionitrile, 3-butoxypropionitrile, methoxyacetonitrile, ethylene glycol, propylene glycol, diethylene glycol, triethylene glycol, dimethoxyethane, diethyl carbonate, diethyl ether, diethyl carbonate, dimethyl carbonate, 1,2-dimethoxyethane, dimethylformamide, dimethyl sulfoxide, 1,3-dioxolane, methyl formate, 2-methyltetrahydrofuran, 3-methoxyoxazolidin-2-one, γ-butyrolactone, sulfolane, tetrahydrofuran and water; and among these, preferable examples include acetonitrile, propylene carbonate, ethylene carbonate, 3-methoxypropionitrile, methoxyacetonitrile, ethylene glycol, diethylene glycol, 3- and γ-butyrolactone. These may be used singly or in combinations of two or more. The concentration of a redox electrolyte in the charge transfer layer is usually 0.01 M to 10 M, preferably 0.1 M to 5 M, and more preferably 0.5 M to 3 M.

In the case where the charge transfer layer is constituted of a form of a composition containing a redox electrolyte, a normal temperature fused salt (ionic liquid) having low volatility is also preferably used as a solvent from the viewpoint of preventing the leakage of the charge transfer layer and improving the durability and reliability of a solar cell. Specific examples of normal temperature fused salts usable include 1-methyl-3-alkylimideolium iodides, vinylimidazolium tetrafluoride, 1-ethylimidazolesulfonates, alkylimidazolium trifluoromethylsulfonylimides and 1-methylpyrrolidinium iodide. In order to improve the durability of a solar cell, the charge transfer layer may be made into a gel or a gelatinous electrolyte, for example by a method of dissolving a low-molecular gelling agent in a charge transfer layer to increase the viscosity, a method of injecting a charge transfer layer concurrently using a reactive component, and then reacting and gelling it, a method of making a charge transfer layer permeate in a gel polymerized in advance, a method of mixing and using a charge transfer layer with an inorganic microparticle of titanium oxide or the like.

Addition of additives to the charge transfer layer is also preferable in order to improve the cell performance including the conversion efficiency, open voltage, short-circuit current, fill factor, moisture resistance reliability and durability of a dye-sensitized photoelectric conversion device and a dye-sensitized solar cell. The additives include, for example, amines such as t-butylpyridine, 1-methylbenzimidazol and 1-methylimidazoliums, and acids such as acetic acid, propionic acid and phosphoric acid. These may be added singly or in combinations of two or more.

In the case where a solid charge transfer layer is used, a hole transport material or a p-type semiconductor may be used in place of a redox electrolyte, The hole transport material usable includes conductive polymers such as amine derivatives, polyacetylene, polyaniline and polythiophene; and the p-type semiconductor includes CuI and CuSCN; and in the case where a dye-sensitized solar cell using no iodine is fabricated, these iodine-free charge transfer layers can be used.

After a charge transfer layer is injected in the gap between a pair of conductive supports, an injection port of the charge transfer layer is sealed to thereby obtain a photoelectric conversion device. A sealant (port-sealant) usable to seal the injection port of the charge transfer layer is an isobutylene resin, an epoxy resin, a UV-curing acrylic resin or the like, and is not limited thereto as long as having an effect of preventing the leakage of a charge transfer layer from the injection port. As the sealant, commercially available sealants can be used, and UV-curing acrylic resins are preferable.

As another fabrication method of a photoelectric conversion device, a method as described in Patent Literature 8 can also be employed in which a weir of a sealing agent is provided on the circumferential part of the conductive surface of one of conductive supports without providing a charge transfer layer injection port, then, the charge transfer layer described above is disposed inside the weir of the sealing agent; and the other conductive support is placed and laminated so that the conductive surfaces of the first and second conductive supports face each other under reduced pressure and a gap is simultaneously formed; and thereafter, the sealing agent is cured to thereby obtain a photoelectric conversion device.

Fig. 1 is an essential-part cross-sectional schematic diagram illustrating a structure of the dye-sensitized photoelectric conversion device according to the present invention. Reference numeral 1 denotes a conductive support having conductivity on the inner side; reference numeral 2 denotes a dye-sensitized semiconductor-containing layer; and reference numerals 1 and 2 collectively denote an oxide semiconductor electrode. Reference 3 denotes a counter electrode in which platinum or the like is disposed on the conductive surface on the inner side of a conductive support; reference numeral 4 denotes a charge transfer layer disposed in the gap between the pair of conductive supports; reference numeral 5 denotes a sealing agent used in the photoelectric conversion device according to the present invention; and reference numeral 6 denotes a glass substrate.

Lead wires are disposed to the positive electrode and the negative electrode of the photoelectric conversion device thus obtained, and a resistance component is inserted between the lead wires to thereby obtain the solar cell according to the present invention.

The sealing agent used in the photoelectric conversion device according to the present invention can be applied also to fabrication of a large-area dye-sensitized solar cell module in which a plurality of dye-sensitized solar cells arranged planarly are electrically connected in series. Although some kinds of module structures of large-area dye-sensitized solar cells are known, the sealing agent used in the photoelectric conversion device according to the present invention can be used in any of the structures, and can preferably be used, for example, for a dye-sensitized solar cell module having a series connection structure described in International Publication WO2009/057704.

The sealing agent used in the photoelectric conversion device according to the present invention prevents the leakage of a charge transfer layer of the photoelectric conversion device, particularly a dye-sensitized photoelectric conversion device, to be thereby able to improve the durability, and is very low in the contamination of the charge transfer layer in the production step, and is excellent in application workability to a substrate, laminating property, adhesive strength, usable time at room temperature (pot life), and low-temperature curability. Therefore, the photoelectric conversion device according to the present invention obtained by using the sealing agent exhibits no operational failures due to the contamination of the charge transfer layer, and is excellent in adhesiveness and moisture resistance reliability; and a solar cell prepared by using the photoelectric conversion device has features of being produced efficiently, and being excellent in the durability and reliability.

## Examples

Hereinafter, the present invention will be described in more detail by way of Examples, but the present invention is not limited to these Examples.

### Sealing Agent Fabrication Example 1

70 parts by mass of RE-310S (trade name, bisphenol A-type epoxy resin, made by Nippon Kayaku Co., Ltd., epoxy equivalent: 185 g/eq., hydrolyzable chlorine amount: 30 ppm), 20 parts by mass of EPPN-501H (trade name,

trisphenolmethane novolac epoxy resin, made by Nippon Kayaku Co., Ltd., epoxy equivalent: 165 g/eq., hydrolyzable chlorine amount: 390 ppm) and 10 parts by mass of a bisphenol A-type solid epoxy resin (epoxy equivalent: 630 g/eq., hydrolyzable chlorine: 550 ppm) as epoxy resins (a), 7.5 parts by mass of PN-152 (trade name, phenol novolac resin, made by Nippon Kayaku Co., Ltd., active hydrogen equivalent- 1.00 g/eq., softening point: 50°C) as a heat curing agent (b), and 1 part by mass of an epoxy silane coupling agent (γ-glycidoxypropyltrimethoxysilane) as a silane coupling agent (d) were heated and dissolved in 30 parts by mass of ethylene glycol dibutyl ether as a solvent. The solution was cooled to room temperature, and thereafter, 19 parts by mass of isophthalic acid dihydrazide finely crushed by a jet mill (melting point: 224°C, active hydrogen equivalent: 48.5 g/eq., average particle diameter: 1.7 μm, maximum particle diameter: 7 μm) as a heat curing agent (b), and 90 parts by mass of an alumina having an average particle diameter of 0.5 μm or smaller and 3.5 parts by mass of a fumed silica as fillers (c) were further added, and mixed and dispersed by a three-roll mill; and 5 parts by mass of a 2,4-diamino-6-[2'methylimidazolyl-(1')]-ethyl]-triazine isocyanuric acid adduct having an average particle diameter of 3 μm or smaller as a curing accelerator was added thereto to thereby obtain a thermosetting sealing agent (1) for a photoelectric conversion device. The viscosity at 25°C of the sealing agent (1) was 50 Pa·s (the viscosity was measured by an E-type viscometer).

Sealing Agent Fabrication Example 2

70 parts by mass of RE-310S, 20 parts by mass of EPPN-501H and 10 parts by mass of a bisphenol A-type solid epoxy resin (epoxy equivalent: 630 g/eq., hydrolyzable chlorine: 550 ppm) as epoxy resins (a), 7.5 parts by mass of PN-152 as a heat curing agent (b), and 1 part by mass of an epoxy silane coupling agent (γ-glycidoxypropyltrimethoxylane as a silane coupling agent (d) were heated and dissolved in 30 parts by mass of ethylene glycol dibutyl ether as a solvent. The solution was cooled to room temperature, and thereafter, 22.5 parts by mass of sebacic acid dihydrazide finely crushed by a jet mill (melting point: 185°C, active hydrogen equivalent: 57.6 g/eq., average particle diameter: 1.7 μm maximum particle diameter. 7 μm) as a heat curing agent (b), and 90 parts by mass of an alumina having an average particle diameter of 0. 5 μm or smaller and 3.5 parts by mass of a fumed silica as fillers (c) were further added, and mixed and dispersed by a three-roll mill; and 5 parts by mass of a 2,4-diamino-6-[2'-methylimidazolyl-(1')]-etayl-s-triazine isocyanuric acid adduct having an average particle diameter of 3 μm or smaller as a curing accelerator was added thereto to thereby obtain a thermosetting sealing agent (2) for a photoelectric conversion device. The viscosity at 25°C of the sealing agent (2) was 40 Pa·s (the viscosity was measured by an E-type viscometer).

Sealing Agent Fabrication Example 3

70 parts by mass of RE-3 20 parts by mass of EPPN-501H and 10 parts by mass of a bisphenol A-type solid epoxy resin (epoxy equivalent: 630 g/eq., hydrolyzable chlorine: 550 ppm) as epoxy resins (a), 7.5 parts by mass of PN-152 as a heat curing agent (b), and 1 part by mass of an epoxy silane coupling agent (γ-glycidoxypropyltrimethoxysilane) as a silane coupling agent (d) were heated and dissolved in 30 parts by mass of ethylene glycol dibutyl ether as a solvent. The solution was cooled to room temperature, and thereafter, 19 parts by mass of isophthalic acid dihydrazide finely crushed by a jet mill (melting 224°C, active hydrogen equivalent: 48.5 g/eq., average particle diameter: 1.7 μm, maximum particle diameter: 7 μm) as a heat curing agent (b), and 90 parts by mass of a silica having an average particle diameter of 0.8 μm or smaller and 3.5 parts by mass of a fumed silica as fillers (c) were further added, and mixed and dispersed by a three-roll mill; and 5 parts by mass of a 2,4-diamino-6-[2'-methytimidazolyl-(1')]-ethyl-s-triazine isocyanuric acid adduct having an average particle diameter of 3 μm or smaller as a curing accelerator was added thereto to thereby obtain a thermosetting sealing agent (3) for a photoelectric conversion device. The viscosity at 25 °C of the sealing agent (3) was 65 Pa·s (the viscosity was measured by an E-type viscometer).

Sealing Agent Fabrication Example 4

70 parts by mass of RE-310S, 20 parts by mass of EPPN-501H and 10 parts by mass of a bisphenol A-type solid epoxy resin (epoxy equivalent: 630 g/eq., hydrolyzable chlorine: 550 ppm) as epoxy resins (a), 35.7 parts by mass of PN- 152 as a heat curing agent (b), and 1 part by mass of an epoxy silane coupling agent (γ-glycidoxypropyltrimethoxysilane) as a silane coupling agent (d) were heated and dissolved in 30 parts by mass of ethylene glycol dibutyl ether as a solvent, The solution was cooled to room temperature, and 90 parts by mass of an alumina having an average particle diameter of 0.5 μm or smaller and 3.5 parts by mass of a fumed silica as fillers (c) were further added, and mixed and dispersed by a three-roll mill; and 5 parts by mass of a 2,4-diamino-6-[2'-methylimidazolyl-1')]-ethyl-s-triazine isocyanuric acid adduct having an average particle diameter of 3 μm or smaller as a curing accelerator was added thereto to thereby obtain a thermosetting sealing agent (4) for a photoelectric conversion device. The viscosity at 25°C of the sealing agent (4) was 43 Pa·s (the viscosity was measured by an E-type viscometer).

Sealing Agent Fabrication Example 5

70 parts by mass of RE-310S, 20 parts by mass of EPPN-501H and 10 parts by mass of a bisphenol A-type solid epoxy resin (epoxy equivalent: 630 g/eq., hydrolyzable chlorine: 550 ppm) as epoxy resins (a), 7.5 parts by mass of PN-152 as a heat curing agent (b), and 1 part by mass of an epoxy silane coupling agent (γ-glycidoxypropyltrimethoxysilane ) as a silane coupling agent (d) were heated and dissolved in 30 parts by mass of ethylene glycol dibutyl ether as a solvent. The solution was cooled to room temperature, and thereafter, 14.3 parts by mass of succinic acid dihydrazide finely crushed by a jet mill (melting point: 147°C, active hydrogen equivalent: 36.5 g/eq., average particle diameter: 1.7 μm, maximum particle diameter: 7 μm) as a heat curing agent (b), and 90 parts by mass of a silica having an average particle diameter of 0.8 μm or smaller and 3.5 parts by mass of a fumed silica as fillers (c) were further added, and mixed and dispersed by a three-roll mill; and 5 parts by mass of a 2,4-diamino-6-[2'-methylimidazol-(1')]-ethyl-s-triazine isocyanuric acid adduct having an average particle diameter of 3 μm or smaller as a curing accelerator was added thereto to thereby obtain a thermosetting sealing agent (5) for a photoelectric conversion device. The viscosity at 25°C of the sealing agent (5) was 60 Pa·s (the viscosity was measured by an E-type viscometer).

Evaluation Test 1

Then, each sealing agent (sealing agents (1) to (5)) obtained in Sealing Agent Fabrication Examples 1 to 5 was measured for the adhesive strength the adhesive strength after a pressure cooker test (PCT), the swelling ratio and the moisture absorptivity. The results are shown in Table 1.
Table 1

| Sealing Agent | (1) | (2) | (3) | (4) | (5) |
|---|---|---|---|---|---|
| Adhesive Strength | 99.7 Pa | 110.9 Pa | 84.3 Pa | 84.9 Pa | 68.8 Pa |
| Strength after PCT | 44.9 Pa | 46.4 Pa | 52.2 Pa | 54.9 Pa | 12.9 Pa |
| Swelling Ratio | 0% | 0% | 0% | 16.2% | 0% |
| Moisture Absorptivity | 1.3% | 1.3 % | 1.4% | 1.1% | 2.0% |

As is clear from table 1, it was found that the sealing agents (1) to (3) were superior in the swelling ratio to the sealing agent (4). The sealing agents (1) to (3) have better performance in the adhesive strength, the adhesive strength after PCT test, and the moisture absorptivity (low hygroscopicity) than the sealing agent (5). That is, it is found the sealing agent used for the photoelectric conversion device according the present invention had better moisture resistance reliability than the conventional sealing agent. Each test was carried out by the following methods.

Adhesive strength

1 part by mass of a glass fiber of 20 μm in diameter as a spacer was added to 100 parts by mass of each sealing agent, and mixed and stirred. The resultant sealing agent was applied on a conductive support (FTO glass substrate) of 50 mm × 50 mm by a dispenser; the solvent was volatilized by heating by a hot plate; thereafter, a glass piece of 2 mm × 2 mm was laminated on the sealing agent on the conductive support, and the sealing agent was cured under the conditions of 150°C and 1 hour; and the obtained test piece was measured for a shearing adhesive strength.

Adhesive strength after PCT test

A test piece fabricated by the same method as used in the measurement of the adhesive strength was subjected to a pressure cooker test (PCT) under the conditions of 121.°C, 2 atm, and a humidity of 100% for 12 hours, and measured for a shearing adhesive strength.

Swelling ratio

Each sealing agent was applied on a polyimide film by using an applicator; the solvent was dried in a drier; and the sealing agent was cured on a hot plate under the conditions of 150°C and 1 and the polyimide film was peeled off to thereby obtain a film-shaped sample of each sealing agent. The film was cut out into a size of 3 cm × 3 cm, and immersed in 3-butoxypropionitrile at 85°C for 2 hours, The swelling ratio was calculated based on the following expression from the masses before and after the immersion.

$$\text{Swelling Ratio [\%]} = (\text{a mass after the immersion} - \text{a mass before the immersion}) / \text{the mass before the immersion} \times 100$$

Moisture absorptivity

A film-shaped sample fabricated by the same method as used in the measurement of the swelling ratio was cut out into a size of 3 cm × 3 cm, and held in a thermohygrostat at 65°C and 90%RH, for 12 hours to absorb moisture. The moisture absorptivity was calculated based on the following expression from an increment in the masses before and after the moisture absorption.

$$\text{Moisture Absorptivity [\%]} = (\text{a mass after the moisture absorption} - \text{a mass before the moisture absorption}) / \text{the mass before the moisture absorption} \times 100$$

Example 1

As shown as an example (Fig. 1) of a photoelectric conversion device, a $TiO_2$ microparticle (average particle diameter: 20 nm) made into the form of paste with terpineol was applied on a conductive surface of an FTO conductive glass support as conductive support by a screen printing machine, and fired at 450°C for 30 min to thereby form a conductive support having a semiconductor-containing layer (film thickness: 10 μm, minor axis width: 5 mm). A dye represented by the formula (1) was dissolved in a concentration of $3.2 \times 10^{-4}$ M in a mixed solvent of 1:1 of acetonitrile and t-butyl alcohol; and the conductive support provided with the semiconductor-containing layer obtained by the above was immersed in the dye solution at room temperature for 48 hours to thereby fabricate an oxide semiconductor electrode. Then, Pt was vapor deposited in 50 Å similarly on a conductive surface of an FTO conductive glass support to thereby fabricate a counter electrode.

[Formula 1]

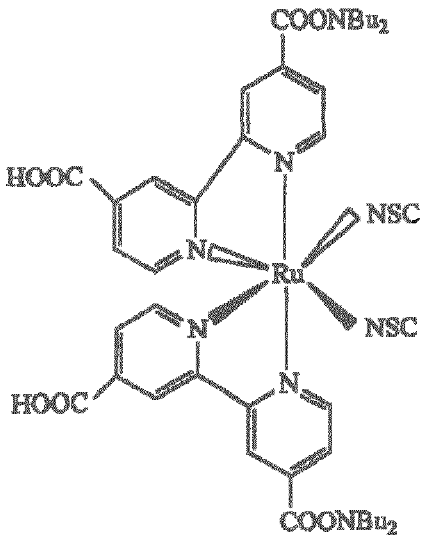

(1)

then, 2.5% by mass of a gold pearl (pearl diameter: 20 μm) as a spacer was added to the sealing agent (1) obtained in Sealing Agent Fabrication Example 1, and mixed and stirred. The resultant sealing agent was applied on the circumference of the counter electrode by using a screen printing machine so that an injection port for a charge transfer layer was left, and heated at 90°C for 18 min by a warm air dryer to remove the solvent. Thereafter, the oxide semiconductor electrode was overlaid on the sealing agent so that the conductive surface of the counter electrode and the semiconductor-containing layer faced each other, and cured at 150°C for 60 min under a pressure of 2.5 kg/$cm^2$ using a hot press machine to thereby obtain a cell of both the conductive supports laminated.

Then, an iodine-based charge transfer layer (iodine/lithium iodide/1-methyl-3-propylimidazolium iodide/1 -methylbenzimidazole were dissolved, respectively, in 0.1 M/0.1 M/1.2 M/0.5 M in 3-butoxypropionitrile) was introduced into the cell obtained in the above from the injection port of the cell, and thereafter, the injection port was sealed with a UV-curable acrylic resin to thereby obtain a photoelectric conversion device (Device 1) according to the present invention.

Example 2

A photoelectric conversion device (Device 2) according to the present invention was obtained as in Example 1, except for changing the sealing agent (1) to the sealing agent (2) in Sealing Agent Fabrication Example 2, in example 1.

Example 3

A photoelectric conversion device (Device 3) according to the present invention was obtained as in Example 1, except for changing the sealing agent (1) to the sealing agent (3) in Sealing Agent Fabrication Example 3, in, example 1.

Comparative Example 1

A photoelectric conversion device for comparison (Device 4) was obtained as in Example 1, except for changing the sealing agent (1) to the sealing agent (4) in Sealing Agent Fabrication Example 4, in example 1.

Evaluation Test 2

Measurement of the photoelectric conversion efficiency

For each photoelectric conversion device obtained in Examples 1 to 3 and Comparative Example 1, lead wires were connected to both the electrodes, and a and an ammeter were arranged to thereby obtain a solar cell according to the present invention. For each solar cell, the photoelectric conversion capability was measured. As a light source, a 1 kW xenon lamp (made by Wacom Co., Ltd.) was used, the incident light density through an AM 1.5 filter was set at 100 mW/cm2. The short-circuit current, the open voltage and the conversion efficiency were measured using a solar simulator (WXS-155S-10, made by Wacom Co., Ltd.). The results are shown in Table 2.
Table 2

| | Short-Circuit Current | Open Voltage | Photoelectric Conversion Efficiency |
|---|---|---|---|
| Device 1 | 30.1 mA | 0.64 V | 5.41 % |
| Device 2 | 30.7 mA | 0.63 V | 5.73 % |
| Device 3 | 29,5 mA | 0.68 V | 5.36 % |
| Device 4 | 28.8 mA | 0.72 V | 5,13 % |

As is clear from Table 2, it is found that the photoelectric conversion devices (Devices 1 to 3) obtained in Examples 1 to 3 developed photoelectric conversion efficiencies equal to or higher than those of the photoelectric conversion device (Device 4) obtained using the conventional sealing agent, and the sealing agent according to the present invention was excellent also as a constituting member of a photoelectric conversion device,

Evaluation Test 3

Test for the moisture resistance reliability of a photoelectric conversion device

2.5% by mass of a gold pearl (pearl diameter: 20 μm) as a spacer was added to each sealing agent obtained in Sealing Agent Fabrication Examples to 4, and mixed and stirred. The resultant sealing agent was applied in the same shape as in the case of the photoelectric conversion devices on the circumference of a 1.1 mm-thick glass substrate by using a screen printing machine so that an injection port for a charge transfer layer was left, and thereafter heated at 90°C for 18 min by a warm air dryer to remove the solvent. Thereafter, another glass substrate was overlaid on the sealing agent, and the sealing agent was cured at 150°C for 60 min under a pressure of 2,5 $kg/cm^2$ using a hot press machine to thereby fabricate a cell of a mock photoelectric conversion device having the same shape as the photoelectric conversion devices,

Then, an iodine-based charge transfer layer (iodine/lithium iodide/1,2-dimethyl-3-propylimidazolium iodide/1-methylbenzimidazole were dissolved, respectively, in 0.1 M/0. M/1.2 M/0.5 M in 3-butoxypropionitrile) was filled in the each cell of the mock photoelectric conversion devices obtained in the above from the injection port of the cell, and thereafter, the injection port was sealed with a UV-curable acrylic resin to thereby obtain respective mock photoelectric conversion devices for a test for the moisture resistance reliability.
Two device samples were fabricated for each of these mock photoelectric conversion devices and Devices 1 to 4 of Examples 1 to 3 and Comparative Example 1, which contained the charge transfer layer; one of the two samples was held in a thermohygrostat at 85°C and 85%RH, and the other sample was held under the conditions (PCT) of 120°C, atm., and a humidity of 100%, and the moisture resistance reliabilities of the devices were evaluated by observing the leakage situations of the charge transfer layers. The results of the mock photoelectric conversion devices are shown in Table 3, and the results of the photoelectric conversion devices are shown in Table 4.
[Table 3]

Table 3 Moisture Resistance Reliabilities of Mock Photoelectric Conversion Devices

| Sealing Agent | Cell Appearance after PCT | Cell Appearance after 85°C and 85%RH |
|---|---|---|
| (1) | The liquid partially leaked | No a liquid leakage even after a time elapse of 1,000 hours |
| (2) | The liquid partially leaked | No liquid leakage even after a time elapse of 864 hours |
| (3) | No liquid leakage, and the initial state was held | No liquid leakage even after a time elapse of 1,000 hours |
| (4) | The liquid wholly leaked, and the substrate was peeled off | The liquid started leaking at a time elapse of 144 hours |

[Table 4]

Table 4 Moisture Resistance Reliabilities of Photoelectric Conversion Devices

| Device | Cell Appearance after PCT | Cell Appearance after 85°C and 85%RH |
|---|---|---|
| 1 | The liquid partially leaked | No liquid leakage even after a timeelapse of 1,000 hours |
| 2 | The liquid partially leaked | No liquid leakage even after a timeelapse of 648 hours |
| 3 | No liquid leakage, and the initial state was held | No liquid leakage even after a time elapse of 1,000 hours |
| 4 | The liquid wholly leaked, and the substrate was peeled off | The liquid started leaking at a time elapse of 72 hours |

As is clear from Table 3 and Table 4, it was found that the mock photoelectric conversion devices and Devices 1 to 3 according to the present invention were superior in the moisture resistance reliability to the mock photoelectric conversion device for comparison and Device 4. That is, it was found that the photoelectric conversion devices according to the present invention ware excellent in the moisture resistance reliability while maintaining the photoelectric conversion characteristics equal to or higher than those of the photoelectric conversion device using the conventional sealing agent.

Evaluation Test 4

Test 2 for the moisture resistance reliability of the photoelectric conversion device

There are shown in Table 5 the results (changes with time of conversion efficiency maintaining rate) of tests for the moisture resistance reliability at a temperature of 85)C and at a humidity of 85% for the photoelectric conversion devices according to the present invention (device 2 and Device 3) and the photoelectric conversion device for comparison (Device 4).
The sealing agents used for Device 2, device 3 and Devices 4 were arranged so that all of the sealing widths thereof became 1.2 mm after the heat curing, The values in Table 5 indicate conversion efficiencies at each time in the case where the conversion efficiencies at the test starting time were taken to be 1.

[Table 5]

| | | Change With Time of Conversion Efficiency Maintaining Rate | | | | | | |
|---|---|---|---|---|---|---|---|---|
| Device | Sealing Agent | 0 hours 90 | hours | 144 hours | 161 hours | 192 hours | 300 hours | 312 hours |
| Device 2 | (2) | 1 | 0.8 | - | 0.687 | - | 0.348 | - |
| Device 3 | (3) | 1 | - | 1 | - | - | - | 0.97 |
| Device 4 | (4) | 1 | - | - | - | 0.15 | - | - |

As is clear from Table 5, under the conditions of a temperature of 85°C and a humidity of 85%, the photoelectric conversion device for comparison (Device 4) exhibited a conversion efficiency maintaining rate of 0.15 (the conversion efficiency was maintained at 15% when the conversion efficiency at 0 hr was taken to be 100%) after a time elapse of 192 hours, Device 2 according to the present invention exhibited a conversion efficiency maintaining rate of 0.348 even after a time elapse of 300 hours, and Device 3 according to the present invention exhibited a conversion efficiency maintaining rate of 0.97 even after the time elapse of 312 hours. That is, it was revealed that Device 2 and Device 3 according to the present invention had a higher conversion efficiency maintaining rate and had better durability and reliability than Device 4 for comparison. Comparing the conversion efficiency maintaining rates of Device and Device 3 after a time elapse of 300 hours or longer, Device 3 exhibited a conversion efficiency maintaining rate 2.78 times or more that of Devices 2, and this is conceivably because the use of an aromatic hydrazide and a phenol novolac resin us heat curing agents (b) in the thermosetting sealing agent (3) for a photoelectric conversion device for Device 3 imparted the sealing agent and the photoelectric conversion device with a high electrolyte solution leakage preventive property.

Industrial Applicability

A thermosetting sealing agent for a photoelectric conversion device used in the photoelectric conversion device according to the present invention is very low in the contamination of a charge transfer layer in a production step of the photoelectric conversion device, and is excellent in application workability to a substrate, laminating property, adhesive strength, usable time at room temperature (pot life) and low-temperature curability. The photoelectric conversion device according to the present invention obtained using such a sealing agent exhibits no operational failures due to contamination of the charge transfer layer, is excellent in adhesiveness and moisture resistance reliability, and has high durability and reliability.

Reference Signs List

1 CONDUCTIVE SUPPORT
2 DYE-SENSITIZED SEMICONDUCTOR-CONTAINING LAYER
3 COUNTER ELECTRODE
4 CHARGE TRANSFER LAYER
5 SEALING AGENT
6 GLASS SUBSTRATE

## Claims

**1.** A photoelectric conversion device, comprising: a first conductive support having a semiconductor-containing layer, a second conductive support having a counter electrode and provided at a position where the semiconductor-containing layer and the counter electrode face each other with a predetermined gap; a charge transfer layer interposed in the gap between the first and the second conductive support; and a sealing agent provided on circumferential parts oaf the first and the second conductive support in order to seal the charge transfer layer, wherein the sealing agent is a thermosetting sealing agent, for a photoelectric conversion device, comprising an epoxy resin (a) and a heat curing agent (b) containing at least one selected from the group consisting of aromatic hydrazides and aliphatic hydrazides having or more carbon atoms.

**2.** The photoelectric conversion device according to claim 1, wherein the heat curing agent (b) contains 0.8 to 3.0 equivalent weights of an active hydrogen with respect to 1 equivalent weight of an epoxy group in the epoxy resin (a).

**3.** The photoelectric conversion device according to claim 1 or 2, wherein at least one of aromatic hydrazides and aliphatic hydrazides haying 6 or more carbon atoms contained in the heat curing agent (b) has two or more hydrazide groups in a molecule thereof.

**4.** The photoelectric conversion device according to any one of claims 1 to 3, wherein the heat curing agent (b) comprises an aromatic hydrazide.

**5.** The photoelectric conversion device according to any one of claims to 4, wherein the heat curing agent (b) further comprises a phenol novolac resin.

**6.** The photoelectric conversion device according to any one of claims 1 to 5, wherein the thermosetting sealing agent for a photoelectric conversion device further comprises a filler (c),

**7.** The photoelectric conversion device according to claim 6, wherein the filler (c) comprises one or two or more selected from the group consisting of hydrous magnesium silicate, calcium carbonate, aluminum oxide, crystalline silica and fused silica, and wherein the filler (c) has an average particle diameter of 15 μm or smaller.

**8.** The photoelectric conversion device according to any one of claims 1 to 7, wherein the thermosetting sealing agent for a photoelectric conversion device further comprises a silane coupling agent (d).

**9.** The photoelectric conversion device according to claim 8, wherein the silane coupling agent (d) is a glycidylethoxysilane or a glycidylmethoxysilane.

**10.** The photoelectric conversion device according to claim 9, wherein the silane coupling agent (d) is a glycidylmethoxysilane.

**11.** A solar cell having the photoelectric conversion device according to any one of claims 1 to 10.

FIG.1

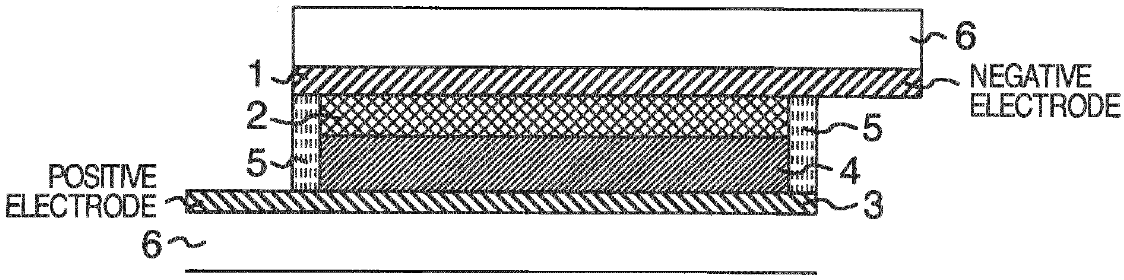

## INTERNATIONAL SEARCH REPORT

International application No.
PCT/JP2011/061166

A. CLASSIFICATION OF SUBJECT MATTER
*H01M14/00*(2006.01)i, *C08G59/44*(2006.01)i, *C08L63/00*(2006.01)i, *H01L31/04*(2006.01)i

According to International Patent Classification (IPC) or to both national classification and IPC

B. FIELDS SEARCHED

Minimum documentation searched (classification system followed by classification symbols)
H01M14/00, C08G59/44, C08L63/00, H01L31/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2007/007671 A1 (Nippon Kayaku Co., Ltd.), 18 January 2007 (18.01.2007), claims 1 to 13; paragraphs [0012] to [0032]; examples & EP 1901390 A1 & US 2009/0114272 A1 & CA 2613987 A & CN 101218707 A & AU 2006267616 A & KR 10-2008-0030649 A | 1-11 |
| X | WO 2007/046499 A1 (Nippon Kayaku Co., Ltd.), 26 April 2007 (26.04.2007), paragraphs [0028] to [0049]; examples & EP 1939972 A1 & US 2009/0250104 A1 & CA 2625344 A & AU 2006305129 A & KR 10-2008-0068666 A & CN 101292391 A | 1-11 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>28 July, 2011 (28.07.11) | Date of mailing of the international search report<br>09 August, 2011 (09.08.11) |
| Name and mailing address of the ISA/<br>Japanese Patent Office<br>Facsimile No. | Authorized officer<br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2002368236 A
- JP 2007087684 A
- WO 2007007671 A
- JP 3731752 B
- JP 2002512729 A
- WO 2002011213 A
- WO 2006126538 A
- WO 2007046499 A
- WO 2006080384 A
- WO 2002001667 A
- WO 2002071530 A
- JP 2002334729 A
- JP 2003007358 A
- JP 2003017146 A
- JP 2003059547 A
- JP 2003086257 A
- JP 2003115333 A
- JP 2003132965 A
- JP 2003142172 A
- JP 2003151649 A
- JP 2003157915 A
- JP 2003282165 A
- JP 2004014175 A
- JP 2004022222 A
- JP 2004022387 A
- JP 2004227825 A
- JP 2005005026 A
- JP 2005019130 A
- JP 2005135656 A
- JP 2006079898 A
- JP 2006134649 A
- WO 2006082061 A
- JP 2008021496 A
- WO 2009020098 A
- JP 2010146864 A
- WO 2010021378 A
- WO 2007100033 A
- WO 2009057704 A

### Non-patent literature cited in the description

- **C. J. BARBE ; F ARENDSE ; P COMPT ; M. GRAETZEL.** *J. Am. Ceram. Soc.,* 1997, vol. 80 (12), 3157-71